(19) Europäisches Patentamt / European Patent Office / Office européen des brevets

(11) **EP 2 959 303 B1**

(12) **FASCICULE DE BREVET EUROPEEN**

(45) Date de publication et mention
de la délivrance du brevet:
**03.07.2024 Bulletin 2024/27**

(21) Numéro de dépôt: **14709206.8**

(22) Date de dépôt: **21.02.2014**

(51) Classification Internationale des Brevets (IPC):
**H02S 50/10** (2014.01)        **G01R 31/52** (2020.01)

(52) Classification Coopérative des Brevets (CPC):
**H02S 50/10; G01R 31/52; Y02E 10/50**

(86) Numéro de dépôt international:
**PCT/EP2014/053395**

(87) Numéro de publication internationale:
**WO 2014/128244 (28.08.2014 Gazette 2014/35)**

(54) **PROCEDE ET DISPOSITIF DE DETECTION D'ARC ELECTRIQUE DANS UNE INSTALLATION PHOTOVOLTAIQUE**

VERFAHREN UND VORRICHTUNG ZUR ERKENNUNG VON LICHTBÖGEN IN EINER PHOTOVOLTAIKANLAGE

METHOD AND DEVICE FOR DETECTING AN ELECTRIC ARC IN A PHOTOVOLTAIC INSTALLATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.02.2013 FR 1351555**

(43) Date de publication de la demande:
**30.12.2015 Bulletin 2015/53**

(73) Titulaire: **Commissariat à l'Énergie Atomique et aux Énergies Alternatives
75015 Paris (FR)**

(72) Inventeurs:
  • **CHAINTREUIL, Nicolas**
    **F-73800 Montmelian (FR)**
  • **GOUY-PAILLER, Cédric**
    **F-78000 Versailles (FR)**
  • **LESPINATS, Sylvain**
    **F-73100 Aix-les-Bains (FR)**
  • **PLISSONNIER, Alexandre**
    **F-38800 Pont-de-Claix (FR)**

(74) Mandataire: **Novaimo
Europa 1
362, avenue Marie Curie
Archamps Technopole
74166 Saint-Julien-en-Genevois Cedex (FR)**

(56) Documents cités:
**WO-A1-2011/017721        WO-A1-2013/083723**

• BRAUN H ET AL: "Signal processing for fault detection in photovoltaic arrays", 2012 IEEE INTERNATIONAL CONFERENCE ON ACOUSTICS, SPEECH AND SIGNAL PROCESSING (ICASSP 2012) : KYOTO, JAPAN, 25 - 30 MARCH 2012 ; [PROCEEDINGS], IEEE, PISCATAWAY, NJ, 25 mars 2012 (2012-03-25), pages 1681-1684, XP032227460, DOI: 10.1109/ICASSP.2012.6288220 ISBN: 978-1-4673-0045-2

• SCHIMPF F ET AL: "Recognition of electric arcing in the DC-wiring of photovoltaic systems", TELECOMMUNICATIONS ENERGY CONFERENCE, 2009. INTELEC 2009. 31ST INTERNATIONAL, IEEE, PISCATAWAY, NJ, USA, 18 octobre 2009 (2009-10-18), pages 1-6, XP031579534, ISBN: 978-1-4244-2490-0

**Description**

L'invention concerne un procédé de détection d'un arc électrique dans un système photovoltaïque. Elle concerne aussi un dispositif de sécurité détectant l'apparition d'arcs électriques, et un module photovoltaïque et un système photovoltaïque équipés d'un tel dispositif de sécurité détectant l'apparition d'arcs électriques.

Les installations photovoltaïques fonctionnent à tension continue et courant continu importants, ce qui engendre des risques d'apparition d'arcs électriques. De tels arcs électriques peuvent survenir suite à une erreur de manipulation, par exemple si un opérateur ouvre malencontreusement un connecteur en charge, ou suite à la dégradation des connexions de l'installation. Ces arcs électriques génèrent une forte chaleur de plasma pendant une durée importante puisque sous tension continue, la valeur de la tension n'est jamais nulle au contraire d'un système alternatif, et sont de ce fait très dangereux pour les personnes et les installations. De plus, l'intégration des modules photovoltaïques dans la toiture des bâtiments risque de déclencher l'incendie des charpentes en cas d'arc électrique.

Les installations photovoltaïques peuvent être reliées au réseau électrique par l'intermédiaire d'un onduleur. Dans une telle configuration, il existe des systèmes de sécurité permettant de détecter un éventuel arc électrique survenant sur la liaison électrique entre un champ de modules photovoltaïques et l'onduleur. Toutefois, ces systèmes sont insuffisants puisqu'un tel arc électrique est susceptible de se produire au niveau d'un module photovoltaïque lui-même. Il n'existe aucune solution de sécurité contre un tel risque.

Le document WO2010072717 de l'état de la technique propose la détection d'un arc électrique dans une installation photovoltaïque sur la base de l'analyse d'une onde ultrasonore et la reconnaissance de la signature ultrasonore d'un arc électrique dans cette onde. Pour cela, cette solution analyse en continu les signatures ultrasonores. Il en résulte une méthode nécessitant un calcul complexe et un dispositif coûteux.

Le document FR2912848 décrit une méthode simplifiée de détection d'un arc électrique à partir de la simple mesure de tension et de la détection de son augmentation rapide. Toutefois, cette méthode est insuffisante pour faire la distinction entre un arc électrique et différents événements distincts qui induisent aussi une augmentation de tension.

L'article F. Schimpf et L. E. Norum, "Récognition of electric arcing in the DC-wiring of photovoltaic systems," (INTELEC 2009 - 31st International Télécommunications Energy Conférence, Incheon, Korea (South), 2009, pp. 1-6) divulgue un algorithme de détection utilisé pour un détecteur d'arc qui est basé sur un filtrage numérique de la tension du module photovoltaïque, des calculs statistiques et une comparaison finale avec une valeur seuil. U

Ainsi, un objet général de l'invention est de proposer une solution de détection d'un arc électrique dans une installation photovoltaïque, simple, peu coûteuse et fiable, afin d'améliorer la sécurité de telles installations.

A cet effet, l'invention repose sur un procédé de détection d'un arc électrique dans une installation photovoltaïque, caractérisé en ce qu'il comprend les étapes suivantes :

- Mesure de valeurs de tension en au moins un endroit du circuit électrique de l'installation photovoltaïque ;
- Numérisation des valeurs de tension mesurées pour former un échantillonnage de données x à partir de la seule mesure de la tension ;
- Calcul d'un premier indicateur de présence d'un arc électrique, à partir d'un calcul statistique sur l'échantillonnage de données x, parmi la variance, une valeur analogue à la variance, ou l'écart interquartile de l'échantillonnage de données ;
- Calcul d'un second indicateur de présence d'un arc électrique, à partir d'un calcul statistique sur l'échantillonnage de données basé sur une ou plusieurs estimations de la moyenne et/ou de la médiane de l'échantillonnage de données ;
- Comparaison des premier et second indicateurs de présence d'un arc électrique avec des seuils respectifs pour en déduire la présence ou non d'un arc électrique au sein de l'installation photovoltaïque.

L'étape de calcul d'un premier indicateur de présence d'un arc électrique peut être basée sur une valeur analogue à la variance et prendre en compte un facteur d'oubli $\Phi$ et/ou l'étape de calcul d'un second indicateur de présence d'un arc électrique peut prendre en compte un facteur d'oubli $\Phi$.

Le facteur d'oubli peut être combiné avec chaque donnée d'échantillonnage x pour permettre de définir un poids de plus en plus faible aux données de l'échantillonnage les plus anciennes à chaque itération, pour prendre en compte l'historique des valeurs mesurées et focaliser l'algorithme sur une période de temps proche.

Le facteur d'oubli peut dépendre d'une fréquence d'échantillonnage.

Le facteur d'oubli peut être constant et choisi en respectant les règles définies par le tableau suivant :

| Fréquence d'échantillonnage $F_{ech}$ | Facteur d'oubli $\Phi$ compris dans l'intervalle |
|---|---|
| 50 - 300 kHz inclus | [0.965 ; 0.975] |

(suite)

| Fréquence d'échantillonnage $F_{ech}$ | Facteur d'oubli $\Phi$ compris dans l'intervalle |
|---|---|
| 301 - 750 kHz inclus | [0.975 ; 0.985] |
| 751 KHz - 8 Mhz inclus | [0.985 ; 0.995] |

L'étape de calcul d'un premier indicateur de présence d'un arc électrique peut comprendre le calcul de trois variables a, b, c à chaque itération fournissant une nouvelle donnée d'échantillonnage x, en tenant compte de l'historique de ces variables a, b, c, le carré de la nouvelle donnée d'échantillonnage $x^2$ et la nouvelle donnée d'échantillonnage x elle-même.

Le calcul d'un premier indicateur de présence d'un arc électrique peut mettre en oeuvre les calculs suivants, répétés pour chaque donnée numérisée x:

- d'abord, on recalcule trois variables a, b, et c de la manière suivante, à partir des valeurs précédentes de ces variables a, b et c :

$$a \leftarrow \Phi\, a + x^2$$

$$b \leftarrow \Phi\, b + x$$

$$c \leftarrow \Phi\, c + 1$$

- ensuite, le premier indicateur y de présence d'arc électrique est calculée par la formule suivante :
-

$$y = \frac{a - b^2/c}{c - 5}$$

Le calcul du second indicateur de présence d'un arc électrique peut mettre en oeuvre les calculs suivants, répétés pour chaque donnée numérisée x:

- d'abord, on recalcule deux variables b et c de la manière suivante, à partir des valeurs précédentes de ces variables b et c :

$$b \leftarrow \Phi\, b + x$$

$$c \leftarrow \Phi\, c + 1$$

où $\Phi$ est un facteur d'oubli compris entre 0 et 1 inclus,
- ensuite, le second indicateur m de présence d'arc électrique est calculé par la formule suivante : m = b / c.

Le calcul du second indicateur de présence d'un arc électrique peut être basé sur une combinaison de deux estimations haute et basse fréquence de la moyenne des données d'échantillonnage.

Le calcul du second indicateur de présence d'un arc électrique peut mettre en oeuvre les calculs suivants, répétés pour chaque donnée numérisée x:

- d'abord, on recalcule deux variables b et c de la manière suivante, à partir des valeurs précédentes de ces variables b et c :

$$b \leftarrow \Phi\, b + x$$

$$c \leftarrow \Phi c + 1$$

où $\Phi$ est un facteur d'oubli compris entre 0 et 1 inclus,

- ensuite, on calcule une première estimation de moyenne haute fréquence $m_{HF}$ par la formule suivante :

$$m_{HF} = \frac{b}{c}$$

- et on calcule une deuxième estimation de moyenne basse fréquence $m_{BF}$ par la formule suivante :

$$m_{BF} = \psi\, m_{BF} + (1 - \psi) m_{HF}$$

où $\psi$ représente un second facteur d'oubli compris entre 0,9 et 1 inclus ou défini en fonction de la fréquence d'échantillonnage par le tableau suivant;

| Fréquence d'échantillonnage $F_{ech}$ | Facteur d'oubli $\Psi$ compris dans l'intervalle |
|---|---|
| 50 - 300 kHz inclus | [0.9 ; 1[ |
| 301- 750 kHz inclus | [0.95 ; 1[ |
| 751 KHz - 8 Mhz | [0.99 ; 1[ |

- puis on calcule le second indicateur à partir des deux moyennes haute et basse fréquences, comme leur différence.

Le procédé de détection d'un arc électrique dans une installation photovoltaïque peut comprendre une phase d'initialisation du traitement lors de l'allumage qui comprend l'élaboration des deux valeurs seuils pour respectivement les deux indicateurs de présence d'un arc électrique à partir des premières mesures de tension.

Si lors de l'étape de comparaison les deux indicateurs de présence d'un arc électrique dépassent leur valeur seuil préétablie, alors il peut être estimé qu'il existe un arc électrique au sein de l'installation photovoltaïque, puis le procédé peut comprendre une étape consistant à intervenir automatiquement sur le circuit électrique de l'installation photovoltaïque en cas de détection d'un arc électrique, pour mettre l'installation photovoltaïque en sécurité.

L'invention porte aussi sur un dispositif de sécurité pour une installation photovoltaïque, comprenant un ou plusieurs capteur(s) de mesure de tension, relié(s) par une liaison de communication à une unité de traitement, comprenant un convertisseur analogique numérique pour numériser les mesures reçues par le ou les capteur(s) de mesure de tension, caractérisé en ce que l'unité de traitement met en oeuvre le procédé de détection d'un arc électrique dans l'installation photovoltaïque tel que décrit précédemment.

L'unité de traitement peut être reliée par un moyen de communication à un dispositif d'intervention dont la fonction est d'interrompre l'arc électrique, pour supprimer tout risque.

L'invention porte aussi sur une installation photovoltaïque, caractérisée en ce qu'elle comprend au moins un dispositif de sécurité tel que décrit ci-dessus.

Ces objets, caractéristiques et avantages de la présente invention seront exposés en détail dans la description suivante d'un mode d'exécution particulier fait à titre non-limitatif en relation avec les figures jointes parmi lesquelles :

La figure 1 illustre schématiquement une installation photovoltaïque.

La figure 2 représente un exemple d'évolution de la tension au sein d'une installation photovoltaïque en fonction du temps en présence d'un arc électrique.

La figure 3 illustre schématiquement un dispositif de sécurité associé à une installation photovoltaïque selon un mode d'exécution de l'invention.

La figure 4 illustre quelques étapes du procédé de détection d'arc électrique au sein d'une installation photovoltaïque selon un mode d'exécution de l'invention.

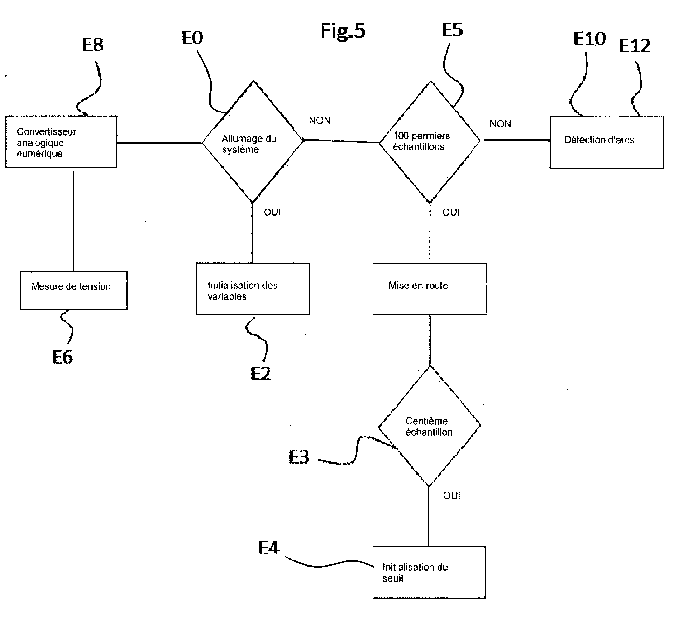

La figure 5 illustre plus globalement la phase initiale du procédé de détection d'arc électrique au sein d'une installation photovoltaïque selon un mode d'exécution de l'invention.

La figure 6 illustre plus globalement la phase de calcul du procédé de détection d'arc électrique au sein d'une installation photovoltaïque selon un mode d'exécution de l'invention.

La figure 7 représente une signature électrique d'un arc série au sein d'une installation photovoltaïque.

La figure 8 représente une signature électrique d'un arc parallèle au sein d'une installation photovoltaïque.

La figure 9 représente une hausse de tension au sein d'une installation photovoltaïque.

La figure 10 représente la tension mesurée incluant une erreur d'acquisition au sein d'une installation photovoltaïque.

La figure 11 représente la tension mesurée au sein d'une installation photovoltaïque en présence d'une perturbation au niveau de son onduleur.

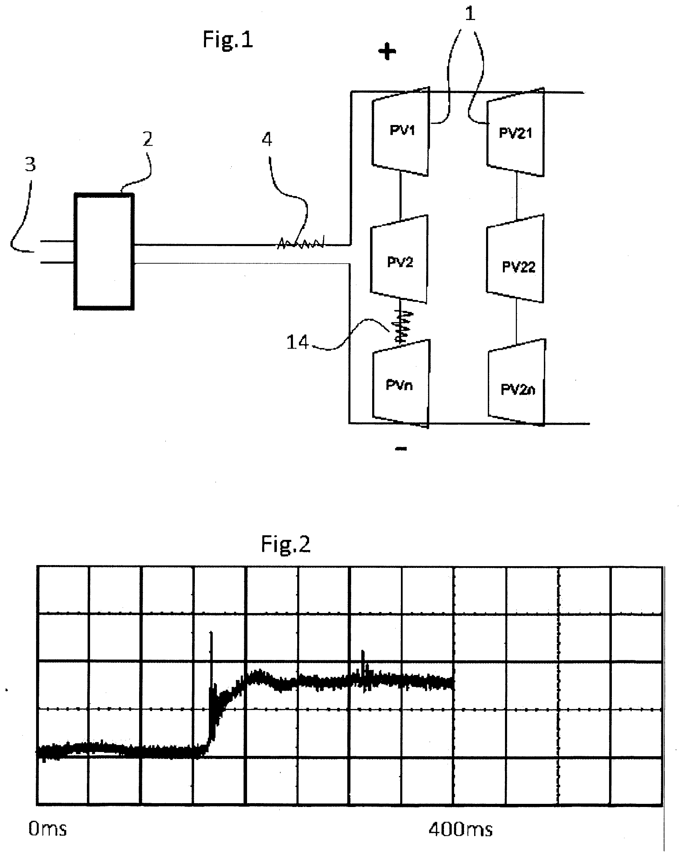

L'invention repose sur la seule mesure de la tension au sein d'une installation photovoltaïque. Cette dernière, représentée schématiquement sur la figure 1, comprend plusieurs modules photovoltaïques 1 (PVi) reliés à un onduleur 2 qui convertit le courant continu produit par les modules photovoltaïques 1 en un courant alternatif, pour une liaison sur un réseau électrique 3 standard, non représenté.

A partir d'une mesure de tension, l'invention cherche à déduire la présence ou non d'un arc électrique au sein d'une installation photovoltaïque. Un tel arc électrique peut se trouver au niveau d'un ou plusieurs module(s) photovoltaïque(s) 1, notamment sur une liaison comprenant plusieurs modules photovoltaïques disposés en série : on parle alors d'arc électrique « série » 14. Un tel arc électrique peut aussi se trouver entre ces modules photovoltaïques et un onduleur 2, ou à tout endroit sur une liaison parallèle à plusieurs modules : on parle alors d'arc électrique « parallèle » 4.

Un arc électrique série provoque une augmentation importante de la tension au sein de l'installation photovoltaïque. Cette tension, mesurée sur une liaison électrique subissant un arc électrique série peut prendre une forme telle qu'illustrée en figure 2 selon un exemple. L'augmentation du signal de tension peut apparaître en même temps que l'arc, et durer de quelques millisecondes à quelques heures. Plus généralement, l'amplitude du signal obtenue dépend de la position du détecteur et d'autres paramètres. Cette augmentation de la tension induit une augmentation de la variabilité du signal.

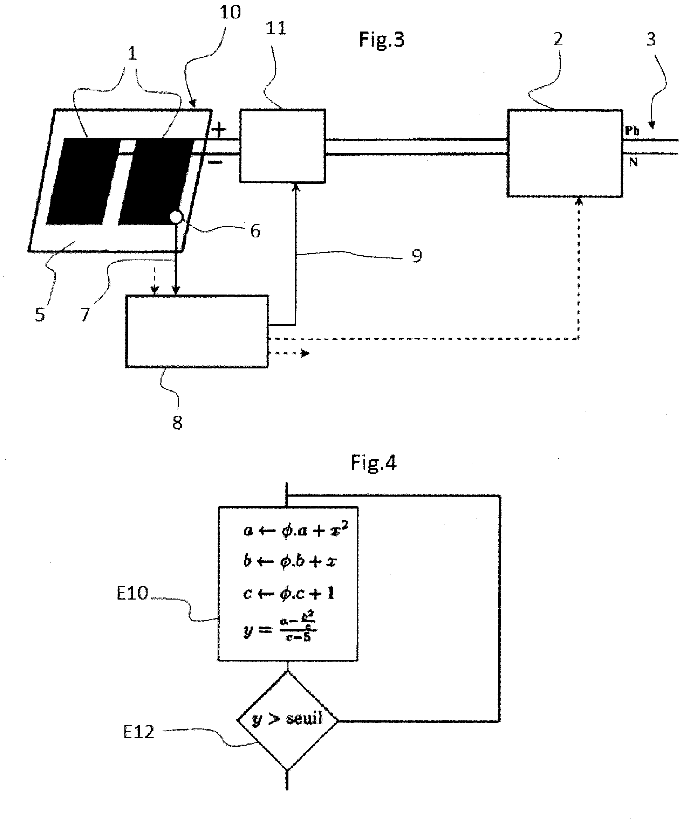

La figure 3 représente schématiquement un dispositif de sécurité pour une installation photovoltaïque 10 telle que décrite sur la figure 1, qui comprend deux modules photovoltaïques 1 à titre d'exemple simplifié montés sur un châssis 5, qui sont reliés au réseau électrique traditionnel 3 par l'intermédiaire d'un onduleur 2. Le dispositif de sécurité comprend un ou plusieurs capteur(s) de mesure de tension 6, positionné(s) par exemple au niveau d'un module photovoltaïque 1 et/ou à tout autre endroit du circuit électrique de l'installation photovoltaïque. Ce (ou ces) capteur de mesure de tension 6 est relié par une liaison de communication 7 à une unité de traitement 8 apte à analyser les données transmises par le(s) capteur(s) de mesure de tension 6. Cette unité de traitement 8 est elle-même reliée par un moyen de communication 9 à un dispositif d'intervention 11 dont la fonction est d'interrompre l'arc électrique sur demande de l'unité de traitement 8 en cas d'arc électrique, pour supprimer tout risque électrique et toute future détérioration.

L'unité de traitement 8 comprend un convertisseur analogique numérique, pour numériser les données reçues provenant du ou des capteur(s) de mesure de tension. Elle a pour fonction d'analyser les données reçues par le(s) capteur(s) de mesure de tension 6 et met en oeuvre un procédé de détection d'arcs électriques, qui sera détaillé ci-dessous. Pour cela, elle peut comprendre une unité de calcul, comme un microcontrôleur, et des moyens de mémorisation, ou plus généralement tout composant matériel (hardware) et/ou logiciel (software). En remarque, comme les données à traiter sont numérisées, il est possible d'utiliser un ou plusieurs microcontrôleurs déjà existant(s) au sein d'une installation photovoltaïque pour mettre en oeuvre le procédé de détection d'arc électrique qui sera détaillé ci-dessous, sans ajout d'un composant additionnel. La solution est donc peu coûteuse.

Enfin, le dispositif de sécurité 10 peut être soit disposé sur une des bornes à la sortie de l'installation photovoltaïque, soit se trouver sur chaque module photovoltaïque, par exemple dans sa boîte de raccordement. Toute solution intermédiaire est naturellement envisageable. Il permet une intervention adaptée au type d'arc électrique détecté, série ou parallèle, et de préférence de manière localisée, au plus proche de la localisation de l'arc électrique.

Le procédé de détection d'arc électrique selon l'invention va maintenant être détaillé.

Il comprend une étape d'échantillonnage de valeurs de tension. Pour cela, différentes valeurs de tension sont mesurées au cours du temps, lors d'une étape de mesure E6, et numérisées, lors d'une étape de numérisation E8, par le convertisseur numérique de l'unité de traitement, selon une fréquence d'échantillonnage $F_{ech}$ choisie. Ensuite, ces valeurs sont traitées pour en déduire une détection d'apparition ou non d'un arc électrique.

Il comprend l'estimation de deux indicateurs complémentaires, selon un calcul parallèle, pour atteindre une détection fiable de la présence d'un arc électrique.

Plusieurs modes de réalisation de l'estimation du premier indicateur vont maintenant être détaillés.

Selon un premier mode de réalisation, pour chaque échantillon de valeurs de tension mesurées et converties par le convertisseur numérique pour fournir des données x, les calculs suivants sont mis en oeuvre :

D'abord, on définit les trois variables a, b, et c de la manière suivante :

$$a \leftarrow \Phi\, a + x^2$$

$$b \leftarrow \Phi\, b + x$$

$$c \leftarrow \Phi\, c + 1$$

où $\Phi$ est un facteur d'oubli, qui est constant et initialisé en fonction de la fréquence d'échantillonnage choisie. A titre d'exemple, le facteur d'oubli peut être défini selon la valeur de la fréquence d'échantillonnage $F_{ech}$ en respectant les règles selon le tableau suivant :

| Fréquence d'échantillonnage $F_{ech}$ | Facteur d'oubli $\Phi$ compris dans l'intervalle |
|---|---|
| 50 - 300 kHz inclus | [0.965 ; 0.975] |
| 301- 750 kHz inclus | [0.975 ; 0.985] |
| 751 KHz - 8 Mhz | [0.985 ; 0.995] |

En variante, ce facteur d'oubli peut ne pas dépendre de la fréquence d'échantillonnage, être par exemple une constante inférieure à 1.

Enfin, le premier indicateur y, qui représente une première valeur d'estimation de présence d'arc électrique, est calculé de la manière suivante :

$$y = \frac{a - b^2/c}{c - 5}$$

Ces calculs des trois variables a, b, c et de l'indicateur y de présence d'arc électrique sont réalisés dans une étape de calcul E10 qui est répétée pour chaque nouvelle donnée x de l'échantillonnage. Ainsi, à chaque itération, les trois variables sont calculées en prenant en compte leurs propres valeurs passées, donc un historique de leurs valeurs, et en prenant en compte le carré de la donnée d'échantillonnage x ainsi que cette donnée d'échantillonnage elle-même.

Finalement, le procédé de détection d'arc électrique comprend une étape de comparaison E12 du premier indicateur y avec un premier seuil, pour en déduire ou non un risque de présence d'un arc électrique.

Si y< seuil1, alors le procédé considère qu'il n'y a pas présence d'un arc électrique. Si y > seuil1, il faut aussi vérifier la valeur d'un second indicateur, comme cela sera explicité plus loin, avant de conclure à la présence d'un arc électrique.

Ce premier mode de réalisation du calcul du premier indicateur permet d'utiliser un indicateur analogue à la variance statistique, c'est-à-dire considérant les différents moments d'ordre 2 des données de l'échantillonnage, mais obtenu de manière plus stable et plus simple grâce à l'introduction des trois variables a, b, c mentionnées et d'un calcul itératif mettant en jeu des calculs très simples.

Ainsi, le principe retenu consiste à définir une valeur d'estimation (premier indicateur) de présence d'un arc électrique liée à la variance (analogue à la variance) des valeurs obtenues lors de l'échantillonnage, combinée à la prise en compte d'un facteur d'oubli $\Phi$,

En effet, selon ce premier mode de réalisation du calcul du premier indicateur, un paramètre, appelé « facteur d'oubli », qui dépend de la fréquence d'échantillonnage $F_{ech}$, est utilisé pour prendre en compte l'historique, proche dans le temps, des valeurs de tension mesurées, et focaliser ainsi l'algorithme sur les dernière mesures. Ce facteur d'oubli permet ainsi par exemple de s'affranchir d'un filtre numérique passe-bande, qui est toujours utilisé dans l'état de la technique pour éliminer certains bruits qui ne sont pas liés à un arc électrique, notamment ceux créés par les signaux de communication qui transitent de l'installation vers l'unité de traitement, et qui présentent notamment la particularité d'être de plus courte durée. D'autre part, le facteur d'oubli, notamment par sa dépendance de la fréquence d'échantillonnage, permet d'optimiser le lien entre la fréquence d'échantillonnage et le traitement effectué, en évitant les adaptations complexes obligatoires entre les filtres passe-bande et la fréquence d'échantillonnage des solutions de l'état de la technique.

L'itération précédente, schématiquement représentée par la figure 4, permet donc d'ajouter un poids inférieur à une donnée plus ancienne qu'une autre, pour tenir compte de l'historique des données obtenues et de leur répartition dans le temps. Tout autre calcul permettant de fixer un poids de plus en plus faible pour chaque donnée obtenue à chaque itération peut permettre d'atteindre en variante un résultat exploitable pour former des variantes de réalisation.

Le procédé de détection d'arc électrique précédemment décrit comprend une étape préliminaire d'initialisation, qui fixe la valeur de seuil en prenant en compte les premières valeurs de tension mesurées à l'allumage E0 du dispositif de sécurité.

A l'instant initial, les variables a, b, c sont initialisées à 0, dans une étape d'initialisation E2, puis calculées selon les formules explicitées ci-dessus. Le facteur d'oubli est de même initialisé en fonction des règles prédéfinies, telles qu'explicitées ci-dessus à titre d'exemple. Ensuite, les calculs tels que présentés à l'étape E10 sont répétés selon un nombre d'itérations prédéfini, par exemple 100 itérations pour prendre en compte 100 échantillons de mesures de tension. Pour cela, le procédé comprend une étape de test E5 de l'atteinte de ce nombre prédéfini d'échantillons d'allumage, pour savoir si le procédé se trouve dans une phase d'initialisation ou dans une phase de fonctionnement normal, mettant en oeuvre les étapes E10, E12 explicitées précédemment. Dans le cadre d'une phase d'initialisation, le procédé met en oeuvre une étape de test de fin d'allumage E3. Lorsque cette fin d'allumage est atteinte, c'est à dire que le nombre prédéfini d'itérations d'allumage est atteint, les variables a, b, c résultantes sont utilisées pour définir une valeur seuil de la manière suivante, à l'étape d'initialisation de la valeur seuil E4 :

$$\text{seuil}= k \,.\, \frac{a- b^2/c}{c-5}$$

où k est un paramètre, choisi entre 5 et 200, selon un compromis choisi entre deux extrêmes : si k est au plus bas, tous les arcs électriques sont détectés, mais il existe un risque de fausse alerte. Si k est plus haut, le risque de fausse détection est réduit mais on augmente le risque de ne pas détecter un arc électrique.

Selon un second mode de réalisation simplifié, le premier indicateur repose sur le simple calcul de la variance statistique. Ce calcul correspond sensiblement à considérer que le facteur d'oubli du premier mode de réalisation présente une valeur égale à 1 les autres calculs et les différentes étapes restant alors similaires aux étapes décrites dans le cas du premier mode de réalisation, et à considérer le premier indicateur y par la formule suivante : $y = a/c - (b/c)^2$ Ce calcul de variance se fera de préférence à partir d'une fenêtre glissante de données x, pour limiter le calcul à un nombre choisi de données, sans prendre en compte les données plus anciennes. Pour cela, le calcul peut être réinitialisé à intervalles réguliers.

Selon un troisième mode de réalisation, le premier indicateur repose sur le calcul de l'écart interquartile. Pour cela, un seuil est élaboré à partir des premières valeurs d'échantillonnage, considérées en l'absence de tout arc électrique, de manière similaire au premier mode de réalisation. Ensuite, une fenêtre glissante est retenue, pour réaliser le calcul de l'écart interquartile à chaque itération, à chaque nouvelle donnée x, sur un nombre prédéterminé de valeurs d'échantillonnage. Cela revient, pour chaque nouvelle donnée obtenue, à supprimer la donnée la plus ancienne considérée à l'itération précédente. Les données sont déjà rangées par ordre croissant (ou décroissant), l'ordre étant issu de l'itération précédente de l'algorithme. Il convient alors de faire entrer la nouvelle donnée dans cet ordre à la place qui convient afin que la relation d'ordre soit préservée. Le premier indicateur correspond alors à l'écart interquartile de l'échantillonnage de données x obtenues à chaque itération sur une fenêtre prédéterminée. Dans ces conditions, le calcul des quartiles est très rapide puisque, modulo le rangement d'une donnée parmi n à chaque itération, les données de la fenêtre glissante sont déjà ordonnées.

Finalement, lors du calcul du premier indicateur, le traitement exploite la constatation que la variabilité du signal augmente significativement pendant l'apparition d'un arc électrique.

Toutefois, le seul premier indicateur ne suffit pas toujours pour identifier de manière satisfaisante la présence d'un arc électrique, et notamment différencier sa présence d'autres phénomènes. C'est pourquoi, le premier indicateur est combiné avec un second indicateur de nature différente, complémentaire.

Ce second indicateur correspond par exemple à la moyenne ou la médiane de l'échantillonnage de données considérées sur une fenêtre glissante de taille prédéfinie. A chaque itération, ce second indicateur est recalculé et comparé à un second seuil. Ce dernier peut aussi être déduit des premières valeurs obtenues lors de la phase d'initialisation E2. En effet, la valeur initiale de la médiane ou de la moyenne forme alors une valeur de référence. Une marge est choisie pour déterminer un second seuil lors de l'étape d'initialisation E4 mentionnée précédemment à partir de cette valeur de référence, au-delà duquel il est considéré que la situation correspond à un risque d'arc électrique.

Selon un mode de réalisation, le calcul du second indicateur est réalisé à partir des variables b et c définies plus haut dans le cadre du premier indicateur, avec le même facteur d'oubli Φ. Ainsi on obtient la valeur suivante estimant la moyenne m par :

$$m = \frac{b}{c}$$

En remarque, si ce facteur d'oubli prend la valeur 1, nous obtenons la moyenne sur l'ensemble des valeurs de l'échantillonnage, alors que toute valeur inférieure à 1 du facteur d'oubli permet de focaliser la moyenne sur les données d'échantillonnage les plus récentes.

Selon un mode de réalisation plus sophistiqué, le second indicateur est basé sur deux estimations glissantes de la moyenne du signal. La première estimation est une estimation appelée moyenne haute fréquence, car elle suit de manière fine le signal en supprimant une partie du bruit. Cette première estimation ou moyenne haute fréquence $m_{HF}$ est calculée à partir des variables b et c définies plus haut et avec le même facteur d'oubli Φ, par la formule suivante :

$$m_{HF} = \frac{b}{c}$$

D'autre part la deuxième estimation est une estimation appelée moyenne basse fréquence car elle va être beaucoup moins rapidement sensible aux variations dans le signal mesuré. Cette estimation de la moyenne basse fréquence est construite à partir de la moyenne haute fréquence définie ci-dessus, de l'ancienne valeur de la moyenne basse fréquence ainsi que d'un second facteur d'oubli ψ très proche de 1, par exemple compris entre 0,9 et 1 inclus, ou plus généralement défini par le tableau ci-dessous, en fonction de la fréquence d'échantillonnage. On définit ainsi la moyenne basse fréquence par la formule suivante :

$$m_{BF} = \psi \, m_{BF} + (1 - \psi) m_{HF}$$

| Fréquence d'échantillonnage $F_{ech}$ | Facteur d'oubli Ψ compris dans l'intervalle |
|---|---|
| 50 - 300 kHz inclus | [0.9 ; 1[ |
| 301- 750 kHz inclus | [0.95 ; 1[ |
| 751 KHz - 8 Mhz | [0.99 ; 1[ |

Finalement, le second indicateur z considéré est la différence entre les deux moyennes haute et basse fréquences :

$$z = m_{HF} - m_{BF}$$

Cet indicateur, qui reste normalement toujours proche de 0 s'il n'y a pas de saut dans la valeur moyenne du signal, est utilisé pour détecter l'apparition d'un arc électrique, par comparaison avec un seuil prédéfini. En variante, tout autre indicateur prenant en compte les deux estimations des moyennes peut être utilisé. De plus, toutes autres formules permettant d'obtenir deux estimations différentes et complémentaires de la moyenne peuvent être utilisées.

Ainsi, d'une manière générale, ce second indicateur sera basé sur une ou plusieurs estimations de la moyenne et/ou de la médiane d'un échantillonnage de données x mesurées.

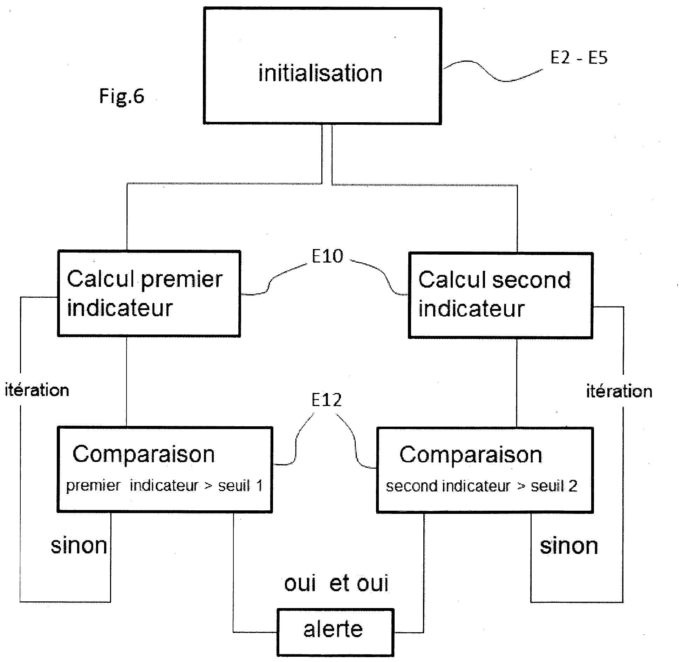

La figure 6 résume l'ensemble du procédé de détection d'arc électrique. Lorsque la phase initiale est terminée, deux valeurs seuils seuil1 et seuil2 sont fixées. Le procédé comprend alors un certain nombre d'itérations au cours desquelles une valeur de tension est mesurée au sein de l'installation photovoltaïque, pour finalement fournir une nouvelle donnée d'échantillonnage x représentant cette mesure de tension. Une étape de calcul E10 comprend la mise en oeuvre du calcul des deux indicateurs à partir d'un échantillonnage comprenant cette donnée x. Une étape de comparaison E12 compare chaque indicateur avec respectivement son seuil seuil1, seuil2, pour en déduire la présence d'un arc électrique uniquement si les deux seuils sont dépassés. Naturellement, ce même procédé est répété à chaque mesure selon la fréquence d'échantillonnage choisie pour toutes les mesures de tension réalisées à différents niveaux de l'installation photovoltaïque. En variante, le calcul des indicateurs peut ne pas être fait à chaque nouvelle donnée x obtenue, mais toutes les n données.

Enfin, lorsqu'un arc électrique est détecté, l'unité de traitement 8 associée à l'installation photovoltaïque envoie automatiquement une commande de mise en sécurité de l'installation photovoltaïque, par l'intermédiaire du dispositif de communication 9 et du dispositif d'intervention 11. Cette mise en sécurité peut reposer sur des interrupteurs commandés à distance. Une commande de mise en sécurité peut représenter un ordre d'interruption du fonctionnement du système photovoltaïque, ce qui peut permettre de stopper l'arc électrique, en supprimant ainsi le risque que représenterait l'entretien de l'arc électrique, notamment le risque d'incendie.

D'autre part, le procédé peut aussi permettre de reconnaitre, à partir de l'échantillonnage de données analysé, si un arc électrique détecté est de type série ou parallèle. Il peut alors engager des actions de mise en sécurité différente dans les deux cas.

Naturellement, le dispositif de sécurité 10 comprend avantageusement plusieurs capteurs de mesure de tension lorsque l'installation photovoltaïque est de grande dimension, par exemple un capteur pour chaque module photovoltaïque, ou pour un module sur deux ou trois, et au moins un capteur par chaine de modules photovoltaïques disposés en série, pour pouvoir détecter tout arc série. Pour obtenir une solution fiable, il est possible d'équiper le dispositif de deux capteurs de mesure de tension par chaine de modules photovoltaïques disposés en série, la redondance de ces capteurs permettant de pallier à une défaillance d'un capteur. Un tel capteur est avantageusement directement associé à un module photovoltaïque particulier, est par exemple directement disposé au sein du boîtier électronique d'un tel module. Le procédé de détection d'arc électrique est mis en oeuvre en parallèle pour chaque mesure de chaque capteur. Cette approche permet ainsi de garantir la sécurité de l'ensemble de l'installation, et de détecter au plus vite tout arc électrique. Elle permet aussi la localisation précise d'un arc électrique, et optionnellement une mise en sécurité localisée de l'installation photovoltaïque.

Le concept de l'invention ne se limite pas aux dispositifs photovoltaïques décrits ci-dessus mais peut être mis en oeuvre dans toute sorte d'installation photovoltaïque, avec de nombreux modules photovoltaïques.

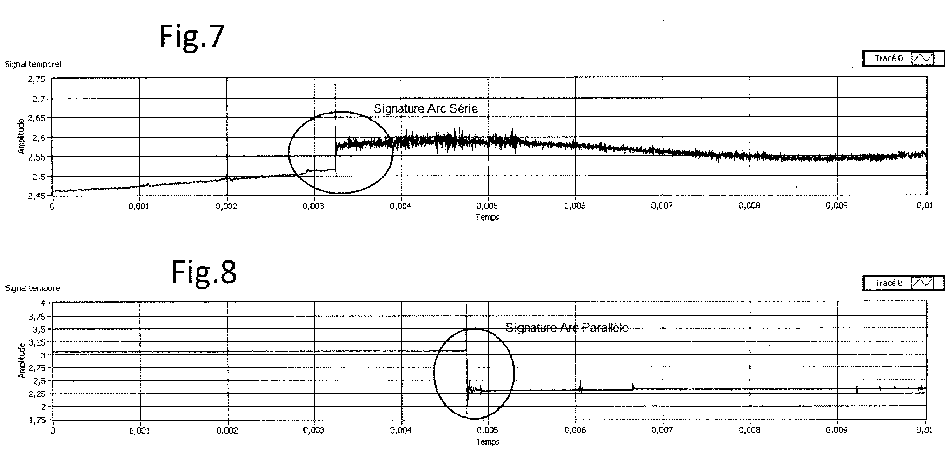

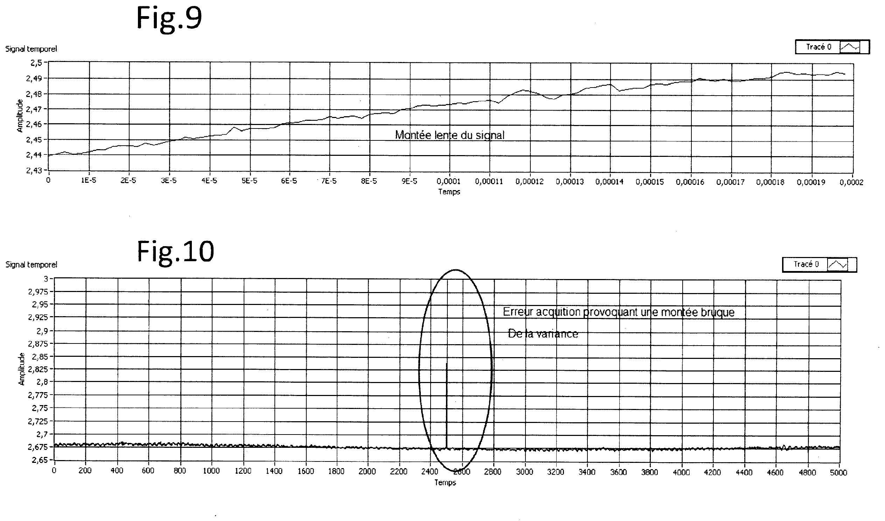

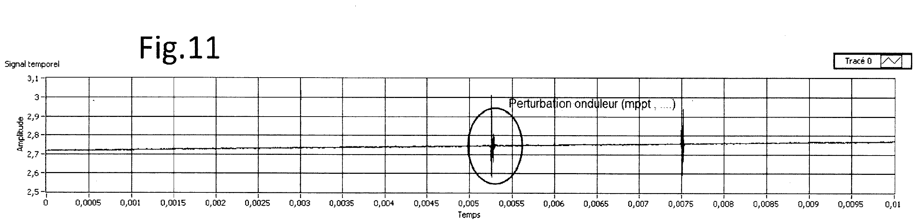

La combinaison des deux indicateurs mentionnés précédemment permet de manière remarquable d'obtenir une reconnaissance fiable de la présence d'un arc électrique dans une installation photovoltaïque avec des calculs très simples, ne nécessitant pas de moyens coûteux, et faciles à mettre en oeuvre en temps réel avec une fréquence d'échantillonnage élevée. Elle permet ainsi par exemple de distinguer l'apparition d'un arc série, dont la signature formée par l'évolution de la tension en fonction du temps est représentée en figure 7, ou l'apparition d'un arc parallèle, dont la signature formée par l'évolution de la tension en fonction du temps est représentée en figure 8. Elle permet de plus d'éviter les fausses détections lors de phénomènes voisins qui ne sont pas causés par un arc électrique, comme une simple montée de la tension telle que représentée en figure 9, une brusque montée ponctuelle de la tension du fait d'une erreur d'acquisition d'une mesure, telle que représentée en figure 10, ou une perturbation de la tension suite à une perturbation du fonctionnement de l'onduleur associé à l'installation photovoltaïque, telle que représentée en figure 11. Naturellement, la fiabilité et le taux de fausses détections du procédé sont réglables, en fonction de la définition des seuils mentionnés. Il sera avantageusement choisi des seuils permettant d'atteindre un taux de détection de 100%, sans grande marge supplémentaire pour minimiser le taux de fausse détection. Le procédé décrit précédemment se prête parfaitement à l'atteinte de cet objectif.

La solution retenue permet donc bien de répondre aux objets recherchés et présente les avantages suivants :

- comme le traitement repose sur la seule mesure de la tension, le procédé est simple ;
- ensuite, comme le procédé met en oeuvre une numérisation pour procéder à de simples calculs statistiques, il est très simple et ne nécessite pas une puissance de calcul importante ;
- ce procédé simplifié permet un calcul très rapide et en temps réel ;
- il atteint une grande fiabilité, tout arc électrique étant détecté, ce qui est très important pour la sécurité ;
- il atteint un taux de fausse détection très bas, ce qui minimise la mise en sécurité de l'installation de manière inutile ;
- enfin, le dispositif est simplifié au maximum et donc peu coûteux, puisqu'il ne nécessite pas de filtre. En variante, il reste compatible avec l'utilisation additionnelle et optionnelle d'un filtre ;
- cette solution est bien sûr compatible et complémentaire avec d'autres solutions de détection d'arc électrique, et peut donc être combinée avec ces autres solutions.

## Revendications

**1.** Procédé de détection d'un arc électrique dans une installation photovoltaïque, comprenant les étapes suivantes :

- Mesure (E6) de valeurs de tension en au moins un endroit du circuit électrique de l'installation photovoltaïque ;

- Numérisation (E8) des valeurs de tension mesurées pour former un échantillonnage de données x à partir de la seule mesure de la tension
- Calcul (E10) d'un premier indicateur de présence d'un arc électrique, à partir d'un calcul statistique sur l'échantillonnage de données x, parmi la variance, une valeur analogue à la variance, ou l'écart interquartile de l'échantillonnage de données ; le procédé étant **caractérisé en ce qu'**il comprend en outre les étapes suivantes:

  - Calcul (E10) d'un second indicateur de présence d'un arc électrique, à partir d'un calcul statistique sur l'échantillonnage de données basé sur une ou plusieurs estimations de la moyenne et/ou de la médiane de l'échantillonnage de données ;
  - Comparaison (E12) des premier et second indicateurs de présence d'un arc électrique avec des seuils respectifs pour en déduire la présence ou non d'un arc électrique au sein de l'installation photovoltaïque.

**2.** Procédé de détection d'un arc électrique dans une installation photovoltaïque selon la revendication précédente, **caractérisé en ce que** l'étape de calcul (E10) d'un premier indicateur de présence d'un arc électrique est basée sur une valeur analogue à la variance et prend en compte un facteur d'oubli $\Phi$ et/ou **en ce que** l'étape de calcul (E10) d'un second indicateur de présence d'un arc électrique prend en compte un facteur d'oubli $\Phi$.

**3.** Procédé de détection d'un arc électrique dans une installation photovoltaïque selon la revendication précédente, **caractérisé en ce que** le facteur d'oubli est combiné avec chaque donnée d'échantillonnage x pour permettre de définir un poids de plus en plus faible aux données de l'échantillonnage les plus anciennes à chaque itération, pour prendre en compte l'historique des valeurs mesurées et focaliser l'algorithme sur une période de temps proche.

**4.** Procédé de détection d'un arc électrique dans une installation photovoltaïque selon la revendication 2 ou 3, **caractérisé en ce que** le facteur d'oubli dépend d'une fréquence d'échantillonnage.

**5.** Procédé de détection d'un arc électrique dans une installation photovoltaïque selon la revendication précédente, **caractérisé en ce que** le facteur d'oubli est constant et choisi en respectant les règles définies par le tableau suivant :

| Fréquence d'échantillonnage $F_{ech}$ | Facteur d'oubli $\Phi$ compris dans l'intervalle |
|---|---|
| 50 - 300 kHz inclus | [0.965 ; 0.975] |
| 301 - 750 kHz inclus | [0.975 ; 0.985] |
| 751 KHz - 8 Mhz inclus | [0.985 ; 0.995] |

**6.** Procédé de détection d'un arc électrique dans une installation photovoltaïque selon l'une des revendications précédentes, **caractérisé en ce que** l'étape de calcul (E10) d'un premier indicateur de présence d'un arc électrique comprend le calcul de trois variables a, b, c à chaque itération fournissant une nouvelle donnée d'échantillonnage x, en tenant compte de l'historique de ces variables a, b, c, le carré de la nouvelle donnée d'échantillonnage $x^2$ et la nouvelle donnée d'échantillonnage x elle-même.

**7.** Procédé de détection d'un arc électrique dans une installation photovoltaïque selon la revendication précédente, **caractérisé en ce que** le calcul d'un premier indicateur de présence d'un arc électrique met en oeuvre les calculs suivants, répétés pour chaque donnée numérisée x:

  - d'abord, on recalcule trois variables a, b, et c de la manière suivante, à partir des valeurs précédentes de ces variables a, b et c :

$$a \leftarrow \Phi\, a + x^2$$

$$b \leftarrow \Phi\, b + x$$

$$c \leftarrow \Phi\, c + 1$$

- ensuite, le premier indicateur y de présence d'arc électrique est calculée par la formule suivante :
-

$$y = \frac{a - b^2/c}{c - 5}$$

8. Procédé de détection d'un arc électrique dans une installation photovoltaïque selon l'une des revendications précédentes, **caractérisé en ce que** le calcul du second indicateur de présence d'un arc électrique met en oeuvre les calculs suivants, répétés pour chaque donnée numérisée x:

- d'abord, on recalcule deux variables b et c de la manière suivante, à partir des valeurs précédentes de ces variables b et c :

$$b \leftarrow \Phi\, b + x$$

$$c \leftarrow \Phi\, c + 1$$

où $\Phi$ est un facteur d'oubli compris entre 0 et 1 inclus,
- ensuite, le second indicateur m de présence d'arc électrique est calculé par la formule suivante : m = b / c.

9. Procédé de détection d'un arc électrique dans une installation photovoltaïque selon l'une des revendications précédentes, **caractérisé en ce que** le calcul du second indicateur de présence d'un arc électrique est basé sur une combinaison de deux estimations haute et basse fréquence de la moyenne des données d'échantillonnage.

10. Procédé de détection d'un arc électrique dans une installation photovoltaïque selon la revendication précédente, **caractérisé en ce que** le calcul du second indicateur de présence d'un arc électrique met en oeuvre les calculs suivants, répétés pour chaque donnée numérisée x:

- d'abord, on recalcule deux variables b et c de la manière suivante, à partir des valeurs précédentes de ces variables b et c :

$$b \leftarrow \Phi\, b + x$$

$$c \leftarrow \Phi\, c + 1$$

où $\Phi$ est un facteur d'oubli compris entre 0 et 1 inclus,
- ensuite, on calcule une première estimation de moyenne haute fréquence $m_{HF}$ par la formule suivante :

$$m_{HF} = \frac{b}{c}$$

- et on calcule une deuxième estimation de moyenne basse fréquence $m_{BF}$ par la formule suivante :

$$m_{BF} = \psi\, m_{BF} + (1 - \psi)m_{HF}$$

où $\psi$ représente un second facteur d'oubli compris entre 0,9 et 1 inclus ou défini en fonction de la fréquence d'échantillonnage par le tableau suivant;

| Fréquence d'échantillonnage $F_{ech}$ | Facteur d'oubli $\Psi$ compris dans l'intervalle |
| --- | --- |
| 50 - 300 kHz inclus | [0.9 ; 1[ |

(suite)

| Fréquence d'échantillonnage $F_{ech}$ | Facteur d'oubli $\Psi$ compris dans l'intervalle |
|---|---|
| 301- 750 kHz inclus | [0.95 ; 1[ |
| 751 KHz - 8 Mhz | [0.99 ; 1[ |

- puis on calcule le second indicateur à partir des deux moyennes haute et basse fréquences, comme leur différence.

11. Procédé de détection d'un arc électrique dans une installation photovoltaïque selon l'une des revendications précédentes, **caractérisé en ce qu'**il comprend une phase d'initialisation du traitement lors de l'allumage (E0) qui comprend l'élaboration des deux valeurs seuils pour respectivement les deux indicateurs de présence d'un arc électrique à partir des premières mesures de tension.

12. Procédé de détection d'un arc électrique dans une installation photovoltaïque selon l'une des revendications précédentes, **caractérisé en ce que** si lors de l'étape de comparaison (E12) les deux indicateurs de présence d'un arc électrique dépassent leur valeur seuil préétablie, alors il est estimé qu'il existe un arc électrique au sein de l'installation photovoltaïque, puis **en ce qu'**il comprend une étape consistant à intervenir automatiquement sur le circuit électrique de l'installation photovoltaïque en cas de détection d'un arc électrique, pour mettre l'installation photovoltaïque en sécurité.

13. Dispositif de sécurité pour une installation photovoltaïque, comprenant un ou plusieurs capteur(s) de mesure de tension (6), relié(s) par une liaison de communication (7) à une unité de traitement (8), comprenant un convertisseur analogique numérique pour numériser les mesures reçues par le ou les capteur(s) de mesure de tension, **caractérisé en ce que** l'unité de traitement (8) met en oeuvre le procédé de détection d'un arc électrique dans l'installation photovoltaïque selon l'une des revendications précédentes.

14. Dispositif de sécurité pour une installation photovoltaïque selon la revendication précédente, **caractérisé en ce que** l'unité de traitement (8) est reliée par un moyen de communication (9) à un dispositif d'intervention (11) dont la fonction est d'interrompre l'arc électrique, pour supprimer tout risque.

15. Installation photovoltaïque, **caractérisée en ce qu'**elle comprend au moins un dispositif de sécurité selon la revendication 13 ou 14.

**Patentansprüche**

1. Verfahren zur Erkennung eines Lichtbogens in einer Photovoltaikanlage, das die folgenden Schritte enthält:

- Messung (E6) von Spannungswerten an mindestens einer Stelle des Stromkreises der Photovoltaikanlage;
- Digitalisierung (E8) der gemessenen Spannungswerte, um eine Stichprobennahme von Daten x ausgehend von der einzigen Messung der Spannung zu bilden,
- Berechnung (E10) eines ersten Präsenzindikators eines Lichtbogens, ausgehend von einer statistischen Berechnung über die Stichprobennahme von Daten x, unter der Varianz, einem Wert analog zur Varianz, oder dem Interquartilsabstand der Stichprobennahme von Daten;

wobei das Verfahren **dadurch gekennzeichnet ist, dass** es außerdem die folgenden Schritte enthält:

- Berechnung (E10) eines zweiten Präsenzindikators eines Lichtbogens, ausgehend von einer statistischen Berechnung über die Stichprobennahme von Daten basierend auf einer oder mehreren Schätzungen des Mittelwerts und/oder des Medians der Stichprobennahme von Daten;
- Vergleich (E12) der ersten und zweiten Präsenzindikatoren eines Lichtbogens mit jeweiligen Schwellen, um daraus die Präsenz oder nicht eines Lichtbogens in der Photovoltaikanlage abzuleiten.

2. Verfahren zur Erkennung eines Lichtbogens in einer Photovoltaikanlage nach dem vorhergehenden Anspruch, **dadurch gekennzeichnet, dass** der Schritt der Berechnung (E10) eines ersten Präsenzindikators eines Lichtbogens auf einem Wert analog zur Varianz basiert und einen Vergessensfaktor Φ berücksichtigt, und/oder dass der Schritt der Berechnung (E10) eines zweiten Präsenzindikators eines Lichtbogens einen Vergessensfaktor Φ berücksichtigt.

3. Verfahren zur Erkennung eines Lichtbogens in einer Photovoltaikanlage nach dem vorhergehenden Anspruch, **dadurch gekennzeichnet, dass** der Vergessensfaktor mit jedem Stichprobennahme-Datenwert x kombiniert wird, um es zu ermöglichen, ein immer schwächeres Gewicht für die ältesten Daten der Stichprobennahme bei jeder Iteration zu definieren, um den Verlauf der gemessenen Werte zu berücksichtigen und den Algorithmus auf eine nahe Zeitperiode zu fokussieren.

4. Verfahren zur Erkennung eines Lichtbogens in einer Photovoltaikanlage nach Anspruch 2 oder 3, **dadurch gekennzeichnet, dass** der Vergessensfaktor von einer Stichprobennahmefrequenz abhängt.

5. Verfahren zur Erkennung eines Lichtbogens in einer Photovoltaikanlage nach dem vorhergehenden Anspruch, **dadurch gekennzeichnet, dass** der Vergessensfaktor konstant ist und unter Beachtung der von der folgenden Tabelle definierten Regeln ausgewählt wird:

| Stichprobennahmefrequenz $F_{ech}$ | Vergessensfaktor Φ enthalten im Intervall |
|---|---|
| **50 - 300 kHz inklusive** | [0.965; 0.975] |
| **301 - 750 kHz inklusive** | [0.975; 0.985] |
| **751 kHz - 8 MHz inklusive** | [0.985; 0.995] |

6. Verfahren zur Erkennung eines Lichtbogens in einer Photovoltaikanlage nach einem der vorhergehenden Ansprüche, **dadurch gekennzeichnet, dass** der Schritt (E10) der Berechnung eines ersten Präsenzindikators eines Lichtbogens die Berechnung von drei Variablen a, b, c bei jeder Iteration enthält, die einen neuen Stichprobennahme-Datenwert x liefert, unter Berücksichtigung des Verlaufs dieser Variablen a, b, c, des Quadrats des neuen Stichprobennahme-Datenwerts $x^2$ und des neuen Stichprobennahme-Datenwerts x selbst.

7. Verfahren zur Erkennung eines Lichtbogens in einer Photovoltaikanlage nach dem vorhergehenden Anspruch, **dadurch gekennzeichnet, dass** die Berechnung eines ersten Präsenzindikators eines Lichtbogens die folgenden Berechnungen durchführt, die für jeden digitalisierten Datenwert x wiederholt werden:

- zunächst werden drei Variablen a, b und c ausgehend von den vorhergehenden Werten dieser Variablen a, b und c folgendermaßen neu berechnet:

$$a \leftarrow \Phi\, a + x^2$$

$$b \leftarrow \Phi\, b + x$$

$$c \leftarrow \Phi\, c + 1$$

- dann wird der erste Indikator y einer Lichtbogenpräsenz durch die folgende Formel berechnet:
-

$$y = \frac{a - b^2/c}{c - 5}$$

8. Verfahren zur Erkennung eines Lichtbogens in einer Photovoltaikanlage nach einem der vorhergehenden Ansprüche, **dadurch gekennzeichnet, dass** die Berechnung des zweiten Präsenzindikators eines Lichtbogens die folgenden Berechnungen durchführt, die für jeden digitalisierten Datenwert x wiederholt werden:

- zunächst werden zwei Variablen b und c ausgehend von den vorhergehenden Werten dieser Variablen b und c folgendermaßen neu berechnet:

$$b \leftarrow \Phi\, b + x$$

$$c \leftarrow \Phi\, c + 1$$

wobei $\Phi$ ein Vergessensfaktor zwischen 0 und 1 inklusive ist,
- dann wird der zweite Indikator m einer Lichtbogenpräsenz durch die folgende Formel berechnet:

$$m = b\ /\ c.$$

9. Verfahren zur Erkennung eines Lichtbogens in einer Photovoltaikanlage nach einem der vorhergehenden Ansprüche, **dadurch gekennzeichnet, dass** die Berechnung des zweiten Präsenzindikators eines Lichtbogens auf einer Kombination von zwei Hoch- und Niederfrequenz-Schätzungen des Mittelwerts der Stichprobennahmedaten basiert.

10. Verfahren zur Erkennung eines Lichtbogens in einer Photovoltaikanlage nach dem vorhergehenden Anspruch, **dadurch gekennzeichnet, dass** die Berechnung des zweiten Präsenzindikators eines Lichtbogens die folgenden Berechnungen durchführt, wiederholt für jeden digitalisierten Datenwert x:

- zunächst werden zwei Variablen b und c ausgehend von den vorhergehenden Werten dieser Variablen b und c folgendermaßen neu berechnet:

$$b \leftarrow \Phi\, b + x$$

$$c \leftarrow \Phi\, c + 1$$

wobei $\Phi$ ein Vergessensfaktor zwischen 0 und 1 inklusive ist,
- dann wird eine erste Hochfrequenz-Mittelwertschätzung $m_{HF}$ durch die folgende Formel berechnet:

$$m_{HF} = \frac{b}{c}$$

- und es wird eine zweite Niederfrequenz-Mittelwertschätzung $m_{BF}$ durch die folgende Formel berechnet:

$$m_{BF} = \psi m_{BF} + (1 - \psi) m_{HF}$$

wobei $\psi$ einen zweiten Vergessensfaktor zwischen 0,9 und 1 inklusive darstellt oder abhängig von der Stichprobennahmefrequenz durch die folgende Tabelle definiert wird:

| Stichprobennahmefrequenz $F_{ech}$ | Vergessensfaktor $\psi$ enthalten im Intervall |
|---|---|
| **50 - 300 kHz inklusive** | [0.9; 1[ |
| **301 - 750 kHz inklusive** | [0.95; 1[ |
| **751 kHz - 8 MHz** | [0.99; 1[ |

- dann wird der zweite Indikator ausgehend von den zwei Hoch- und Niederfrequenz-Mittelwerten als ihre Differenz berechnet.

**11.** Verfahren zur Erkennung eines Lichtbogens in einer Photovoltaikanlage nach einem der vorhergehenden Ansprüche, **dadurch gekennzeichnet, dass** es eine Initialisierungsphase der Verarbeitung beim Zünden (E0) enthält, die die Erarbeitung der zwei Schwellenwerte für die zwei Präsenzindikatoren eines Lichtbogens ausgehend von den ersten Spannungsmessungen enthält.

**12.** Verfahren zur Erkennung eines Lichtbogens in einer Photovoltaikanlage nach einem der vorhergehenden Ansprüche, **dadurch gekennzeichnet, dass**, wenn im Vergleichsschritt (E12) die zwei Präsenzindikatoren eines Lichtbogens ihren vorab erstellten Schwellenwert überschreiten, geschätzt wird, dass ein Lichtbogen in der Photovoltaikanlage existiert, dann, dass es einen Schritt enthält, der darin besteht, im Fall der Erkennung eines Lichtbogens automatisch auf den Stromkreis der Photovoltaikanlage einzuwirken, um die Photovoltaikanlage in Sicherheit zu versetzen.

**13.** Sicherheitsvorrichtung für eine Photovoltaikanlage, die einen oder mehrere Spannungsmesssensor(en) (6) enthält, der(die) durch eine Kommunikationsverbindung (7) mit einer Verarbeitungseinheit (8) verbunden ist(sind), die einen Analog-Digital-Wandler enthält, um die von dem oder den Spannungsmesssensor(en) empfangenen Messwerte zu digitalisieren, **dadurch gekennzeichnet, dass** die Verarbeitungseinheit (8) das Verfahren zur Erkennung eines Lichtbogens in der Photovoltaikanlage nach einem der vorhergehenden Ansprüche anwendet.

**14.** Sicherheitsvorrichtung für eine Photovoltaikanlage nach dem vorhergehenden Anspruch, **dadurch gekennzeichnet, dass** die Verarbeitungseinheit (8) durch eine Kommunikationseinrichtung (9) mit einer Eingreifvorrichtung (11) verbunden ist, deren Aufgabe es ist, den Lichtbogen zu unterbrechen, um jede Gefahr zu beseitigen.

**15.** Photovoltaikanlage, **dadurch gekennzeichnet, dass** sie mindestens eine Sicherheitsvorrichtung nach Anspruch 13 oder 14 enthält.

**Claims**

**1.** Method for detecting an electric arc in a photovoltaic installation, comprising the following steps:

- Measurement (E6) of voltage values at at least one site of the electrical circuit of the photovoltaic installation;
- Digitization (E8) of the measured voltage values so as to form a data sampling x from the only measurement of the voltage;
- Computation (E10) of a first indicator of presence of an electric arc, on the basis of a statistical computation on the data sampling x, from among the variance, a value analogous to the variance, or the interquartile range of the data sampling; the method being **characterized in that** it comprises the following steps
- Computation (E10) of a second indicator of presence of an electric arc, on the basis of a statistical computation on the data sampling based on one or more estimations of the mean and/or of the median of the data sampling;
- Comparison (E12) of the first and second indicators of presence of an electric arc with respective thresholds so as to deduce therefrom the presence or absence of an electric arc within the photovoltaic installation.

**2.** Method for detecting an electric arc in a photovoltaic installation according to the preceding claim, **characterized in that** the step (E10) of computing a first indicator of presence of an electric arc is based on a value analogous to the variance and takes into account a forgetting factor $\Phi$ and/or **in that** the step (E10) of computing a second indicator of presence of an electric arc takes into account a forgetting factor $\Phi$.

**3.** Method for detecting an electric arc in a photovoltaic installation according to the preceding claim, **characterized in that** the forgetting factor is combined with each sampling datum x so as to make it possible to define an ever smaller weight to the oldest data of the sampling at each iteration, so as to take into account the history of the measured values and focus the algorithm on a near time period.

**4.** Method for detecting an electric arc in a photovoltaic installation according to Claim 2 or 3, **characterized in that** the forgetting factor depends on a sampling frequency.

**5.** Method for detecting an electric arc in a photovoltaic installation according to the preceding claim, **characterized in that** the forgetting factor is constant and chosen by complying with the rules defined by the following table:

| Sampling frequency $F_{smp}$ | Forgetting factor $\Phi$ lies in the interval |
|---|---|
| 50 - 300 kHz inclusive | [0.965 ; 0.975] |
| 301 - 750 kHz inclusive | [0.975 ; 0.985] |
| 751 KHz - 8 Mhz inclusive | [0.985 ; 0.995] |

6. Method for detecting an electric arc in a photovoltaic installation according to one of the preceding claims, **characterized in that** the step (E10) of computing a first indicator of presence of an electric arc comprises the computation of three variables a, b, c at each iteration providing a new sampling datum x, by taking account of the history of these variables a, b, c, the square of the new sampling datum $x^2$ and the new sampling datum x itself.

7. Method for detecting an electric arc in a photovoltaic installation according to the preceding claim, **characterized in that** the computation of a first indicator of presence of an electric arc implements the following computations, repeated for each digitized datum x:

   - firstly, three variables a, b, and c are recomputed in the following manner, on the basis of the previous values of these variables a, b and c:

$$a \leftarrow \Phi\,a + x^2$$

$$b \leftarrow \Phi\,b + x$$

$$c \leftarrow \Phi\,c + 1$$

   - thereafter, the first indicator y of presence of electric arc is computed through the following formula:
   -

$$y = \frac{a - b^2/c}{c - 5}$$

8. Method for detecting an electric arc in a photovoltaic installation according to one of the preceding claims, **characterized in that** the computation of the second indicator of presence of an electric arc implements the following computations, repeated for each digitized datum x:

   - firstly, two variables b and c are recomputed in the following manner, on the basis of the previous values of these variables b and c:

$$b \leftarrow \Phi\,b + x$$

$$c \leftarrow \Phi\,c + 1$$

   where $\Phi$ is a forgetting factor lying between 0 and 1 inclusive,
   - thereafter, the second indicator m of presence of electric arc is computed through the following formula: m = b / c.

9. Method for detecting an electric arc in a photovoltaic installation according to one of the preceding claims, **characterized in that** the computation of the second indicator of presence of an electric arc is based on a combination of two high and low frequency estimations of the mean of the sampling data.

10. Method for detecting an electric arc in a photovoltaic installation according to the preceding claim, **characterized in that** the computation of the second indicator of presence of an electric arc implements the following computations, repeated for each digitized datum x:

- firstly, two variables b and c are recomputed in the following manner, on the basis of the previous values of these variables b and c:

$$b \leftarrow \Phi\, b + x$$

$$c \leftarrow \Phi\, c + 1$$

where $\Phi$ is a forgetting factor lying between 0 and 1 inclusive,
- thereafter, a first high-frequency mean estimation $m_{HF}$ is computed through the following formula:

$$m_{HF} = \frac{b}{c}$$

- and a second low-frequency mean estimation $m_{LF}$ is computed through the following formula:

$$m_{LF} = \psi\, m_{LF} + (1 - \psi) m_{HF}$$

where $\psi$ represents a second forgetting factor lying between 0.9 and 1 inclusive or defined as a function of the sampling frequency by the following table;

| Sampling frequency $F_{smp}$ | Forgetting factor $\Psi$ lies in the interval |
|---|---|
| 50 - 300 kHz inclusive | [0.9 ; 1] |
| 301 - 750 kHz inclusive | [0.95 ; 1] |
| 751 KHz - 8 Mhz | [0.99 ; 1] |

- then the second indicator is computed on the basis of the two means, high and low frequency, as their difference.

11. Method for detecting an electric arc in a photovoltaic installation according to one of the preceding claims, **characterized in that** it comprises a phase of initializing the processing during the ignition (E0) which comprises the devising of the two threshold values for respectively the two indicators of presence of an electric arc on the basis of the first voltage measurements.

12. Method for detecting an electric arc in a photovoltaic installation according to one of the preceding claims, **characterized in that** if, during the comparison step (E12) the two indicators of presence of an electric arc exceed their pre-established threshold value, then it is estimated that an electric arc exists within the photovoltaic installation, then **in that** it comprises a step consisting in intervening automatically on the electrical circuit of the photovoltaic installation in case of detection of an electric arc, so as to make the photovoltaic installation safe.

13. Safety device for a photovoltaic installation, comprising one or more voltage measurement sensor(s) (6), linked by a communication link (7) to a processing unit (8), comprising an analogue-digital converter for digitizing the measurements received by the voltage measurement sensor(s), **characterized in that** the processing unit (8) implements the method for detecting an electric arc in the photovoltaic installation according to one of the preceding claims.

14. Safety device for a photovoltaic installation according to the preceding claim, **characterized in that** the processing unit (8) is linked by a communication means (9) to an intervention device (11) whose function is to interrupt the electric arc, so as to eliminate any risk.

**15.** Photovoltaic installation, **characterized in that** it comprises at least one safety device according to Claim 13 or 14.

## Fig.1

## Fig.2

0ms                                                    400ms

**Fig.3**

**Fig.4**

$$a \leftarrow \phi.a + x^2$$
$$b \leftarrow \phi.b + x$$
$$c \leftarrow \phi.c + 1$$
$$y = \frac{a - \frac{b^2}{c}}{c - 5}$$

E10

E12  $y > \text{seuil}$

## Fig.5

E8

E0

E5

E10  E12

Convertisseur
analogique
numérique

Allumage du
système

NON

100 permiers
échantillons

NON

Détection d'arcs

OUI

OUI

Mesure de tension

Initialisation des
variables

Mise en route

E6

E2

Centième
échantillon

E3

OUI

E4

Initialisation du
seuil

Fig.6

initialisation                    E2 - E5

Calcul premier        E10        Calcul second
indicateur                        indicateur

itération                                              itération

Comparaison           E12        Comparaison
premier indicateur > seuil 1      second indicateur > seuil 2

sinon                                                  sinon

oui et oui

alerte

Fig.7

Fig.8

# Fig.9

Signal temporel

Tracé 0

Montée lente du signal

Temps

# Fig.10

Signal temporel

Tracé 0

Erreur acquition provoquant une montée brusque

De la variance

Temps

## Fig.11

## RÉFÉRENCES CITÉES DANS LA DESCRIPTION

**Documents brevets cités dans la description**

- WO 2010072717 A

- FR 2912848

**Littérature non-brevet citée dans la description**

- **F. SCHIMPF ; L. E. NORUM.** Récognition of electric arcing in the DC-wiring of photovoltaic systems. *INTELEC 2009 - 31st International Télécommunications Energy Conférence, Incheon, Korea (South),* 2009, 1-6